Europäisches Patentamt

European Patent Office

Office européen des brevets

(19)

(11) **EP 1 619 407 A1**

(12) **EUROPEAN PATENT APPLICATION**

(43) Date of publication:
**25.01.2006 Bulletin 2006/04**

(51) Int Cl.:
*F16F 7/10* (2006.01)          *G03F 7/20* (2006.01)
*F16F 15/02* (2006.01)

(21) Application number: **05015330.3**

(22) Date of filing: **14.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **20.07.2004 JP 2004211961**

(71) Applicant: **CANON KABUSHIKI KAISHA**
**Ohta-ku, Tokyo (JP)**

(72) Inventor: **Mayama, Takehiko**
**Tokyo (JP)**

(74) Representative: **TBK-Patent**
**Bavariaring 4-6**
**80336 München (DE)**

(54) **Exposure apparatus and semiconductor device manufacturing method**

(57)     An exposure apparatus includes a base (1), a stage device (51) which is mounted on the base and moves in a predetermined direction, a counter mass (52a,52b) which is mounted on the base and moves in a direction opposite to the predetermined direction as the stage device moves, a sensor (61) which detects a motion physical value of each of the stage device and counter mass, and an actuator (11) which applies a force to the base on the basis of a detection result of the sensor.

# F I G.  1

**Description**

FIELD OF THE INVENTION

The present invention relates to an exposure apparatus and a semiconductor device manufacturing method which utilizes the same and, more particularly, to an exposure apparatus having a mechanism which effectively suppresses vibration generated by driving a stage device, and a semiconductor device manufacturing method which utilizes the exposure apparatus.

BACKGROUND OF THE INVENTION

As the accuracy of a semiconductor exposure apparatus increases, a higher-performance vibration-damping, vibration control technique is sought for. This is because when vibration occurs in a structure that forms an exposure stage or exposure apparatus main body, it adversely affects exposure. Therefore, a technique is required which insulates the exposure apparatus main body from vibration outside the exposure apparatus, e.g., from an apparatus installation pedestal, and effectively and quickly decreases vibration generated by the operation of a device which includes a driving means, e.g., a stage device, mounted on the exposure apparatus main body.

The semiconductor exposure apparatus drives a stage device, where a reticle as the original of a pattern or a substrate such as a silicon wafer to be exposed with the pattern is mounted, with an intermittent operation pattern such as step & repeat or step & scan. When the stage device is driven with this operation pattern, a reaction force is generated. This reaction force should not cause vibration in the exposure apparatus main body. This is because if vibration occurs in the exposure apparatus main body, it adversely affects the performance of the stage device as well as that of an optical system and measurement system which are mounted on the same base and vibration-damping bed where the stage device is mounted.

In order to meet this demand, in the semiconductor exposure apparatus, an active vibration-damping device has been developed and employed widely. According to the active vibration-damping device, vibration and position information of the base where the exposure apparatus main body is mounted are detected by sensors. The detection signals are compensated for and fed back to an actuator which applies a control force to the base. A signal from a device including a driving means, e.g., the stage device, mounted on the vibration-damping bed is compensated for and fed forward to the actuator. Thus, vibration of the base and vibration-damping bed is suppressed actively to control their positions and postures.

Japanese Patent Laid-Open No. 11-294520 discloses such an active vibration-damping device and an example in which the active vibration-damping device is applied to a semiconductor exposure apparatus. Japanese Patent Laid-Open No. 11-294520 discloses the following active vibration-damping device and a semiconductor exposure apparatus which uses the same. Pneumatic springs which support a vibration-damping bed on an apparatus installation pedestal are utilized as air actuators. An electromagnetic driving linear motor is also employed which is arranged dynamically parallel to the pneumatic spring and applies a control force between the vibration-damping bed and apparatus installation pedestal. Thus, vibration of the vibration-damping bed is decreased and suppressed.

According to this exposure apparatus, the position information (displacement), acceleration information, and the like of the vibration-damping bed are detected by sensors and compensated for to obtain a signal. Also, a signal from a device having a driving means, e.g., a stage device, mounted on the vibration-damping bed is compensated for to obtain a signal. Each actuator is controlled on the basis of the two obtained signals and the like.

In particular, an active vibration-damping device on which a base where a stage device having a driving unit is mounted is placed, the following control scheme is employed as in exposure apparatuses disclosed in Japanese Patent Laid-Open Nos. 11-294520 and 10-311364. A signal corresponding to the driving reaction force of the stage device mounted on the base is fed forward to actuators which apply a control force to the base of the active vibration-damping device, to quickly decrease and attenuate the vibration.

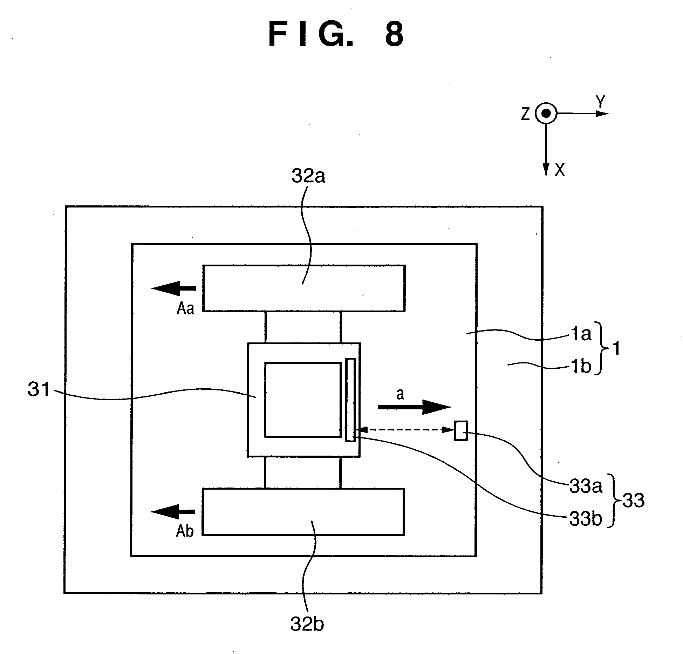

Recently, an exposure apparatus has been developed in which the driving reaction force of a stage device is canceled by a counter mass system to suppress a force acting on a base where the stage device is mounted, so that the base will not be vibrated. Fig. 8 is a view for explaining the operation of a stage system which uses a counter mass system.

The stage system shown in Fig. 8 is driven by a linear motor. The stage system includes a stage device 31 on which a placing target is to be mounted, and counter masses 32a and 32b. The stage device 31 is connected to the movable element of the linear motor and operates together with the movable element of the linear motor. The counter masses 32a and 32b are connected to the stator of the linear motor. The stator of the linear motor forms part of the counter masses 32a and 32b. The counter masses 32a and 32b are supported on a base 1 (1a and 1b) where the stage device 31 is mounted through a structure which includes pneumatic pads or the like and is movable with low friction along a guide bearing, and move in the direction of substantially the same degree of freedom as that of the movable element of the linear motor.

In a conventional stage device, the stator of a linear motor is firmly connected to a base on which the entire stage device is mounted. In the above counter mass system, the stator of the linear motor is supported on the base 1 where the stage device 31 is mounted through the movable structure.

In this stage device, when the linear motor is driven to operate the stage, the energy and momentum of the stage driving reaction force form the kinetic energy and momentum of the counter masses which include the stator and load mass of the linear motor. In an ideal state, the force is not transmitted to the base.

In the stage device 31 shown in Fig. 8, a signal obtained by a position sensor 33 (33a and 33b) which detects the position information of the stage device 31 is compensated for by a compensator (not shown), and the linear motor is driven on the basis of the obtained signal, so that the stage device 31 is controlled. Upon driving the stage device 31, if an acceleration occurs in the stage device 31 in a direction of an arrow a, the driving reaction force of the stage device 31 generates accelerations in the counter masses 32a and 32b in directions of arrows Aa and Ab shown in Fig. 8.

In this manner, the energy and momentum of the stage driving reaction force form the kinetic energy and momentum of the counter masses 32a and 32b which include the linear motor stator and load mass to suppress any force from acting on the base 1. In an ideal state, the force is not transmitted to the base 1. Consequently, the base 1 where the stage device 31 including these constituent elements is mounted does not vibrate largely. The stage device 31 which employs the counter masses 32a and 32b in this manner can be suitably used in a semiconductor exposure apparatus.

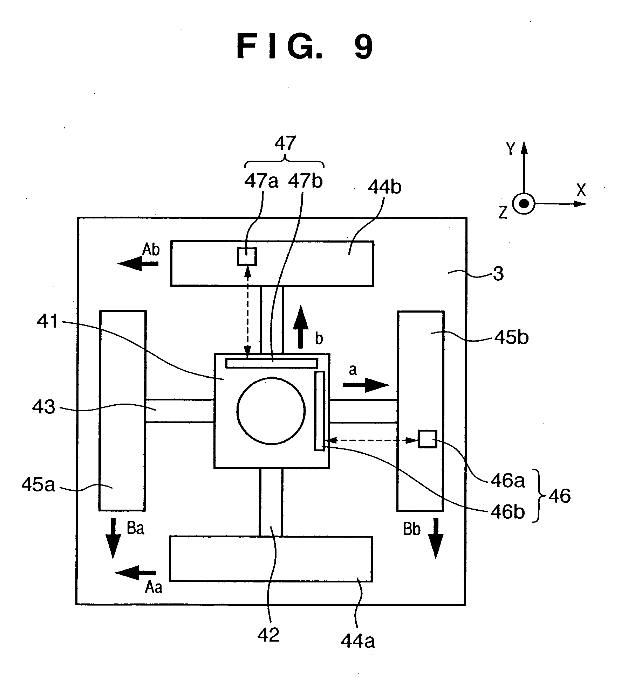

The stage system shown in Fig. 8 is described as one which functions in the moving direction of one degree of freedom. A stage device, e.g., an X-Y stage, which has two degrees of kinetic freedom can similarly form a stage system which uses counter masses. Fig. 9 is a view showing an example of the arrangement of a counter mass system on an X-Y stage which is a stage device having two degrees of kinetic freedom.

In the X-Y stage shown in Fig. 9, a stage device 41 on which a placing target is to be mounted is a structure which can move in the directions of two degrees of freedom, e.g., X and Y directions, and can be moved in the X direction by an X-direction moving member 42 and in the Y direction by a Y-direction moving member 43. The stage device 41 is horizontally supported on a crossbar structure formed of the X-direction moving member 42 and Y-direction moving member 43 which do not restrict the operations of each other, and can move in both the X and Y directions.

An X-direction linear motor applies a thrust between the X-direction moving member 42 and X-direction counter masses 44a and 44b. In this case, the X-direction moving member 42 serves as a movable element, and the X-direction counter masses 44a and 44b serve as stators. Similarly, a Y-direction linear motor applies a thrust between the Y-direction moving member 43 and Y-direction counter masses 45a and 45b. In this case, the Y-direction moving member 43 serves as a movable element, and the Y-direction counter masses 45a and 45b serve as stators. The X-direction counter masses 44a and 44b and Y-direction counter masses 45a and 45b are supported on the base 3 where an X-Y stage is mounted through structures that can respectively move in the X and Y directions.

In a conventional X-Y stage, the stators of the linear motors are firmly connected to a base on which the entire stage device is mounted. In the counter mass system, the counter masses which are firmly connected to the stators of the linear motors are supported on the base where the stage device is mounted through the movable structure.

In this stage device, when the linear motors are driven to operate the X-Y stage, the energy and momentum of the stage driving reaction force form the kinetic energy and momentum of the counter masses which include the linear motor stators and load masses in both the X and Y directions. Accordingly, in an ideal state, the force is not transmitted to the base, and consequently the base where the stage device including these constituent elements is mounted is not vibrated largely.

In the stage system shown in Fig. 9, signals obtained by position sensors 46 (46a and 46b) and 47 (47a and 47b) which detect the position information of the stage device 41 are compensated for by a compensator (not shown), and the linear motors are driven on the basis of the obtained signals, so that the stage device 41 is controlled. Upon driving the stage device 41, if an acceleration occurs in the stage device 41 and X-direction moving member 42 in a direction of an arrow a, the driving reaction forces of the stage device 41 and X-direction moving member 42 generate accelerations in the X-direction counter masses 44a and 44b in directions of arrows Aa and Ab shown in Fig. 9. If an acceleration occurs in the stage device 41 and Y-direction moving member 43 in a direction of an arrow b, the driving reaction forces of the stage device 41 and Y-direction moving member 43 generate accelerations in the Y-direction counter masses 45a and 45b in directions of arrows Ba and Bb in Fig. 9.

In this manner, the energies and momenta of the stage driving reaction forces form the kinetic energies and momenta of the counter masses which include the linear motor stators and load masses to suppress any force from acting on a base 3. In an ideal state, the force is not transmitted to the base. Consequently, the base 3 where the stage device including these constituent elements is mounted does not vibrate largely. Hence, a stage device which employs such counter masses in this manner can be suitably used in a semiconductor exposure apparatus.

As described above, in the stage system which uses these counter masses, the stage device and counter masses are operated at accelerations and with operation strokes that match their mass ratio, so that the momenta in both the stage device and counter masses are theoretically reserved, and the forces acting on the base and vibration-damping bed where the stage device is mounted can be decreased to be very small. Also, the position of center of gravity of the entire movable object including the stage and counter masses joined together can be made substantially immovable.

Also, a method can also be employed which includes, in addition to the structure described above, actuators for externally applying a control force to the counter masses. The positions, velocities, and accelerations of the counter masses as well as the stage device are controlled by the actuators so that the counter masses are operated actively. In this case, since the operations of the counter masses as well as the stage device can be controlled, for example, the stroke over of the counter masses can be avoided. Thus, the exposure apparatus can run in a more appropriate state. In this case, basically, the counter masses are driven by the driving reaction force of the stage device. Thus, substantially no thrust is generated in the actuators which externally apply a control force to the counter masses.

In the counter mass system described above, the driving reaction force of the stage device is canceled by a mechanism that does not include a base, and vibration occurring in the base where the semiconductor exposure apparatus is mounted can be decreased. This is different from the conventional general vibration control scheme of feeding forward the driving reaction force of the stage device to the actuator of the active vibration-damping device. Therefore, the stage driving reaction force and the feed-forward force of the actuator which applies a control force to the base do not cause the structural resonance of the base or do not deform the base. The base vibration can be decreased and suppressed more preferably.

In the stage system employing the conventional counter mass system, sometimes the driving reaction force cannot be completely canceled. To completely cancel the driving reaction force of the stage device by using the counter mass system, ideally, two stage devices having completely the same specification and characteristics must be arranged such that their axes in which driving reaction forces occur coincide with each other completely, and the two stages must be operated under completely the same operation conditions.

In actual design and application of an apparatus, it is very difficult to arrange two stage devices having completely the same specifications such that their axes in which driving reaction forces occur coincide with each other completely. This is because very often the arrangement and design of the unit are spatially limited.

Therefore, as a stage system which employs a counter mass system, the following arrangement is a feasible embodiment. The movable elements of linear motors which drive the stage system are attached to the stage device. The stators of the linear motors are attached to counter masses. The counter masses are supported to be movable with respect to the stage device and a base where the unit of the stage device is mounted. This arrangement is described with reference to Figs. 8 and 9.

Sometimes, however, the kinetic energy, momentum, driving reaction force, and the like of the stage device are not entirely transmitted to the counter masses due to the friction force and damping force generated in bearings (not shown in Figs. 8 and 9) and by the influence or the like of the wiring lines and pipes arranged among the base, stage device, and counter masses. In this case, the kinetic energy and momentum of the stage device do not balance with the kinetic energy and momentum of the counter masses. The difference in kinetic energy and momentum is transmitted to the base where the stage device and counter masses are both mounted. Consequently, vibration occurs in the base.

As described above, when the operations of the counter masses are also to be controlled actively so that the counter mass system functions, the mass ratio of the stage device to counter masses is a very important control parameter. Unless the control operation is performed to precisely reflect the mass ratio, the momentum cannot be reserved between only the stage device and counter masses, and consequently a thrust is transmitted to the base where the stage device is mounted, thus vibrating the base. In practice, the stage device and counter masses are structures having comparatively large weights, and accordingly it is difficult to obtain their masses sufficiently accurately and to reflect them in the control operation. Due to the variations in thrust characteristics of the actuators that drive the stage device and counter masses and other disturbances, sometimes the control parameters of the counter mass system need adjustment. In this case, a parameter corresponding to the mass ratio must be adjusted in a trial-and-error manner. If parameter adjustment is not performed sufficiently accurately, the counter mass system does not operate appropriately, and a thrust acts on the base to vibrate it.

## SUMMARY OF THE INVENTION

The present invention has been made in view of the above problems, and has as its object to provide an apparatus and method which decrease the influence, which is caused by the driving reaction force of a stage device in a base where the stage device is mounted and which cannot be sufficiently canceled even by a counter mass system, to decrease and suppress vibration of the base.

According to the first aspect of the present invention, there is provided an exposure apparatus comprising a base, a stage device which is mounted on the base and moves in a predetermined direction, a counter mass which is mounted on the base and moves in a direction opposite to the predetermined direction as the stage device moves, a sensor which detects a motion physical value of each of the stage device and counter mass, and an actuator which applies a force to the base on the basis of a detection result of the sensor.

According to the second aspect of the present invention, there is provided a semiconductor device manufacturing method comprising an exposure step of transferring a pattern of an original onto a substrate by using an exposure apparatus described above, and a developing step of developing the substrate on which the pattern has been transferred.

According to the present invention, there is provided an apparatus and method which decrease the influence, which is caused by the driving reaction force of a stage device in a base where the stage device is mounted and which cannot be sufficiently canceled even by a counter mass system, to decrease and suppress the vibration of the base.

Other features and advantages of the present invention will be apparent from the following description taken in conjunction with the accompanying drawings, in which like reference characters designate the same or similar parts throughout the figures thereof.

BRIEF DESCRIPTION OF THE DRAWINGS

The accompanying drawings, which are incorporated in and constitute a part of the specification, illustrate embodiments of the invention and, together with the description, serve to explain the principles of the invention.

Fig. 1 is a plan view showing the structure of an exposure apparatus according to the first preferred embodiment of the present invention;

Fig. 2 is a side view showing the structure of the exposure apparatus according to the first preferred embodiment of the present invention;

Fig. 3 is a block diagram showing the structure of the exposure apparatus according to the first preferred embodiment of the present invention;

Fig. 4 is a plan view showing the structure of an exposure apparatus according to the second preferred embodiment of the present invention;

Fig. 5 is a side view showing the structure of the exposure apparatus according to the second preferred embodiment of the present invention;

Fig. 6 is a block diagram showing the control configuration of the exposure apparatus according to the second preferred embodiment of the present invention;

Fig. 7 is a view showing the structure of an exposure apparatus according to a preferred embodiment of the present invention;

Fig. 8 is a view showing an example of a stage device including a conventional counter mass system;

Fig. 9 is a view showing another example of the stage device including the conventional counter mass system; and

Fig. 10 is a flowchart showing the flow of an entire semiconductor device manufacturing process.

DETAILED DESCRIPTION OF THE PREFERRED EMBODIMENTS

Exposure apparatuses according to the preferred embodiments of the present invention will be described with reference to the accompanying drawings.

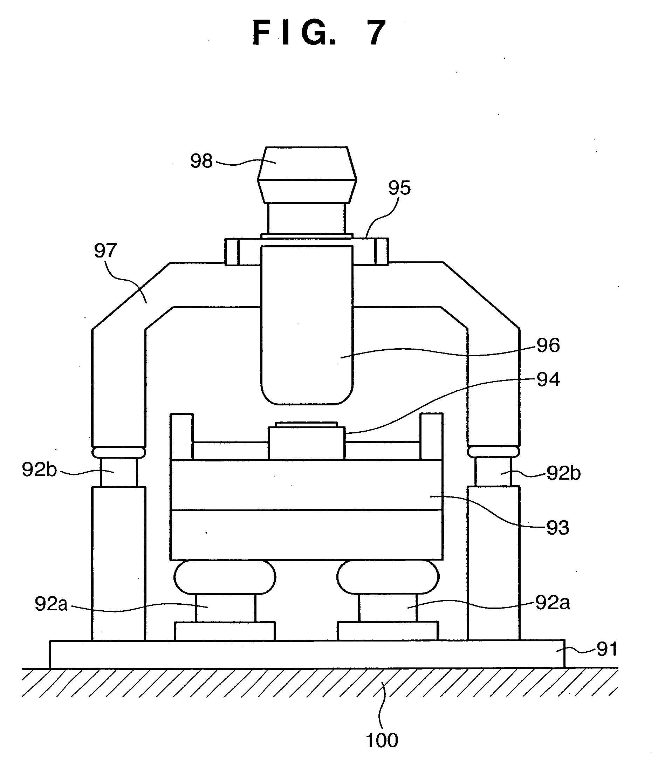

Fig. 7 is a view showing an example of the structure of an exposure apparatus according to a preferred embodiment of the present invention. In the apparatus shown in Fig. 7, a stage base 93 and a substrate stage device 94 mounted on the stage base 93 are set on an apparatus installation foundation 100 through anti-vibration support mounts 92a. The substrate stage device 94 is used to place on it a substrate (e.g., a silicon wafer) on which a pattern is to be exposed. On the apparatus installation foundation 100, a lens barrel base 97 which mounts a reticle stage device 95 and an optical lens system 96 is set through anti-vibration support mounts 92b. The optical lens system 96 is used to transfer the pattern of an original called a reticle onto the substrate.

The anti-vibration support mounts 92a and 92b are not directly set on the apparatus installation foundation 100 but are fixed on a foundation structure 91 called a pallet or base frame. The foundation structure 91 serves as a reference to maintain the mutual positional relationship between devices respectively mounted on the anti-vibration support mounts 92a and 92b and, although not shown in Fig. 7, between other devices which form an exposure apparatus and are not mounted on the anti-vibration support mounts 92a and 92b. The foundation structure 91 also serves as a foundation member to place the entire exposure apparatus and transport the exposure apparatus collectively.

The optical lens system 96 is arranged between the reticle stage device 95 and substrate stage device 94. Exposure light from an illumination optical system 98 radiates the reticle to project and expose a pattern on the reticle onto the substrate through the optical lens system 96.

Exposure apparatuses are classified into collective exposure type (stepper), scanning exposure type (scanner), and the like according to the exposure schemes. In the case of a collective exposure type exposure apparatus, while the substrate stage device 94 is driven sequentially by an intermittent operation scheme called step & repeat, a certain constant exposure area, e.g., an area corresponding to one integrated circuit such as an IC, is exposed collectively. In the case of a scanning exposure type exposure apparatus, the substrate stage device 94 and reticle stage device 95 are operated in synchronism with each other to scan and expose the pattern on the reticle onto the substrate.

In the semiconductor exposure apparatus according to the preferred embodiment of the present invention, with the above structure, when a counter mass system as described above is applied to at least one of the substrate stage device 94 and reticle stage device 95, the influence of the driving reaction force which is applied by the stage device 94 or 95 to the stage base 93 and lens barrel base 97 where the stage device 94 and 95 are mounted and which cannot be completely canceled by the counter mass system is decreased to decrease and suppress the vibration of the base 93 or 97.

[First Embodiment]

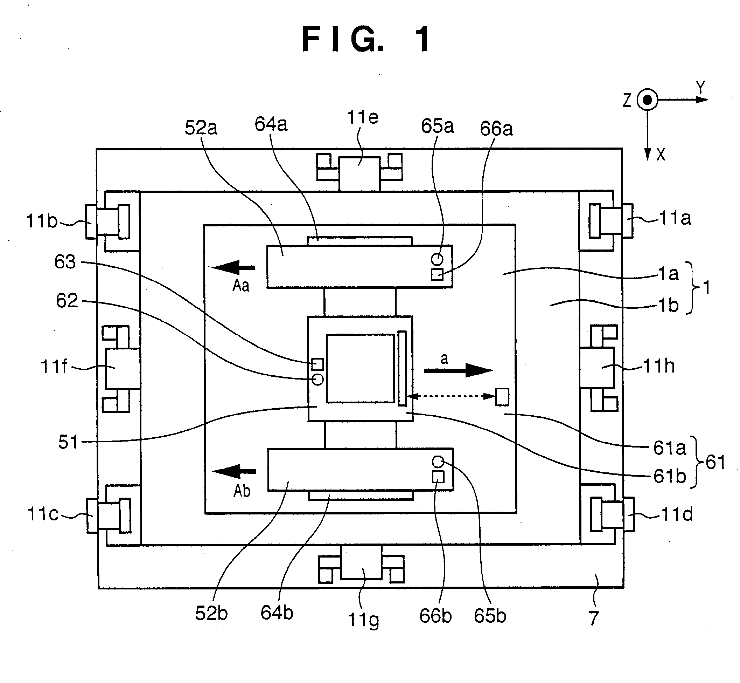

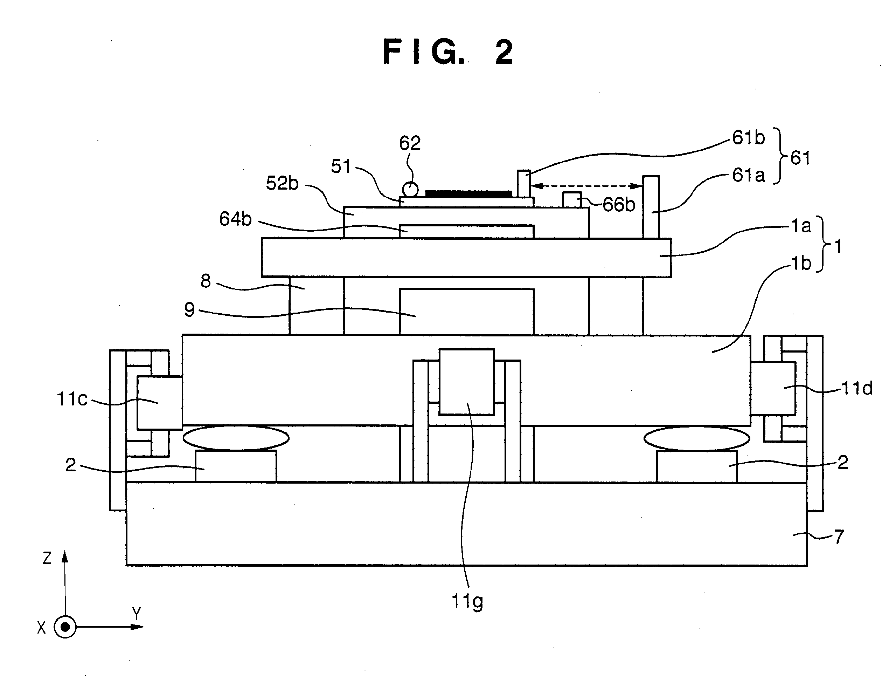

Figs. 1 and 2 are views for explaining the structure and operation of a unit around a stage device that forms an exposure apparatus according to the first preferred embodiment of the present invention. Figs. 1 and 2 show a stage device having a kinetic freedom in the direction of one degree of freedom. Fig. 1 is a plan view of the exposure apparatus, and Fig. 2 is a side view of the exposure apparatus. This unit corresponds to the reticle stage device 95 in the exposure apparatus shown in Fig. 7.

In this manner, the reticle stage device 95 is a stage device which has one degree of kinetic freedom. Actually, the stage device sometimes has not only one degree of freedom in a Y direction shown in Fig. 1 but also a kinetic freedom in X, θz, or the like for reticle alignment. Note that a comparatively large driving reaction force is generated in one degree of freedom, i.e., in the Y direction in which the reticle stage device 95 is scanned.

As the substrate stage device 94, a stage device having two degrees of freedom directions, e.g., an X-Y stage, is employed to repeatedly expose the pattern on the reticle in order to print a plurality of patterns onto the substrate. This will be described later.

A stage device having a kinetic freedom in a direction of one degree of freedom will be described. As shown in Figs. 1 and 2, the semiconductor exposure apparatus according to the first preferred embodiment of the present invention schematically has the following constituent elements. More specifically, the semiconductor exposure apparatus according to this embodiment includes a stage device 51 which places on it a placing target such as a reticle and accurately positions the placing target, and counter masses 52a and 52b serving as inertia masses which operate in the direction of the same degree of freedom as the stage device 51.

The stage device 51 is supported by a structure on which a placing object such as a reticle is mounted and which can move in the direction of one predetermined degree of freedom (the Y direction in Figs. 1 and 2) determined on a base 1 (1a and 1b). The stage device 51 is driven by a linear motor. The stage device 51 is connected to the movable element of the linear motor, and operates together with the movable element of the linear motor. The counter masses 52a and 52b are connected to the stator of the linear motor. The counter masses 52a and 52b are supported on the base 1 where the stage device 51 is mounted through a structure which includes pneumatic pads or the like and is movable with low friction along a guide bearing, and operate in the direction of the same degree of freedom as that of the movable element of the linear motor.

In this stage system, when the stage device 51 is driven by the linear motor, its driving reaction force acts on the counter masses 52a and 52b to operate in the direction of the same degree of freedom as that of the stage device 51 but in the opposite direction. The stator of the linear motor which drives the stage device 51 is supported on the base where the stage device 51 is mounted through the movable structure. Even when the linear motor is driven to operate the stage device, the energy and momentum of the stage driving reaction force form the kinetic energy and momentum of the counter masses including the linear motor stators and load masses. Consequently, in an ideal state, the force is not transmitted to the base, and the stage can be operated without largely vibrating the base where the stage system including these constituent elements is mounted.

In the semiconductor exposure apparatus according to this embodiment, sensors are employed for the stage device 51, having the above structure, and the counter masses 52a and 52b to detect their motion physical values. More specifically, the stage device 51 includes a position sensor 61 (61a and 61b) which detects and outputs the position information of the stage device 51, a velocity sensor 62 which detects and outputs the velocity information of the stage device 51, and an acceleration sensor 63 which detects and outputs the acceleration information of the stage device 51. The position sensor 61, velocity sensor 62, and acceleration sensor 63 respectively detect the motion physical values, i.e., the position information, velocity information, and acceleration information in the operating direction of the stage device 51.

The counter masses 52a and 52b respectively include position sensors 64a and 64b which detect and output the position information of the corresponding counter masses, velocity sensors 65a and 65b which detect and output the velocity information of the corresponding counter masses, and acceleration sensors 66a and 66b which detect and output the acceleration information of the corresponding counter masses. The position sensors 64a and 64b, velocity sensors 65a and 65b, and acceleration sensors 66a and 66b respectively detect the motion physical values, i.e., the position information, velocity information, and acceleration information in the operating direction of the counter masses 52a and 52b.

As the position sensor 61 which detects and outputs the position information of the stage device 51, a laser interferometer which is widely used in this field because of the requirements in accuracy or the like can be used. As the velocity sensor 62 which detects and outputs the velocity information of the stage device 51, a geophone sensor or another velocity sensor can be used. As the acceleration sensor 63 which detects and outputs the acceleration information of the stage device 51, various types of servo or piezoelectric accelerometers can be used.

When a laser interferometer is used as the position sensor 61, in place of using the velocity sensor 62 and acceleration sensor 63, even if the motion physical values of the output signals of the laser interferometer are converted appropriately to calculate the velocity and acceleration, good operation can be performed.

Similarly, as the position sensors 64a and 64b which detect and output the position information of the respective counter masses 52a and 52b, various types of position sensors such as laser interferometers or encoders can be used.

As the velocity sensors 65a and 65b which detect and output the velocity information of the counter masses 52a and 52b, geophone sensors or another type of velocity sensors can be used. As the acceleration sensors 66a and 66b which detect and output the acceleration information of the counter masses 52a and 52b, various types of servo or piezoelectric accelerometers can be used.

When laser interferometers are used as the position sensors 64a and 64b, in place of using the velocity sensors 65a and 65b and acceleration sensors 66a and 66b, even if the motion physical values of the output signals from the laser interferometers are converted appropriately to calculate velocities and accelerations, good operation can be performed.

In employing a control scheme to be described later, assume that the apparatus operates without any problem when at least one of the sensors is omitted. In this case, at least one of the position sensors 61, 64a, and 64b, at least one of the velocity sensors 62, 65a, and 65b, and at least one of the acceleration sensors 63, 66a, and 66b may be omitted.

The stage system which includes the stage device 51 and counter masses 52a and 52b described above is mounted on the base 1. The base 1 is supported in an anti-vibration manner on a foundation structure 7 set on an apparatus installation foundation by anti-vibration supports 2. In the structure shown in Figs. 1 and 2, the base 1 includes the two structures 1a and 1b which are firmly connected to each other through support members 8. Alternatively, the base 1 may be an integral structure. In Fig. 2, the stage device 51 is assumed to be a reticle stage device to form an optical lens system 9 of the exposure apparatus.

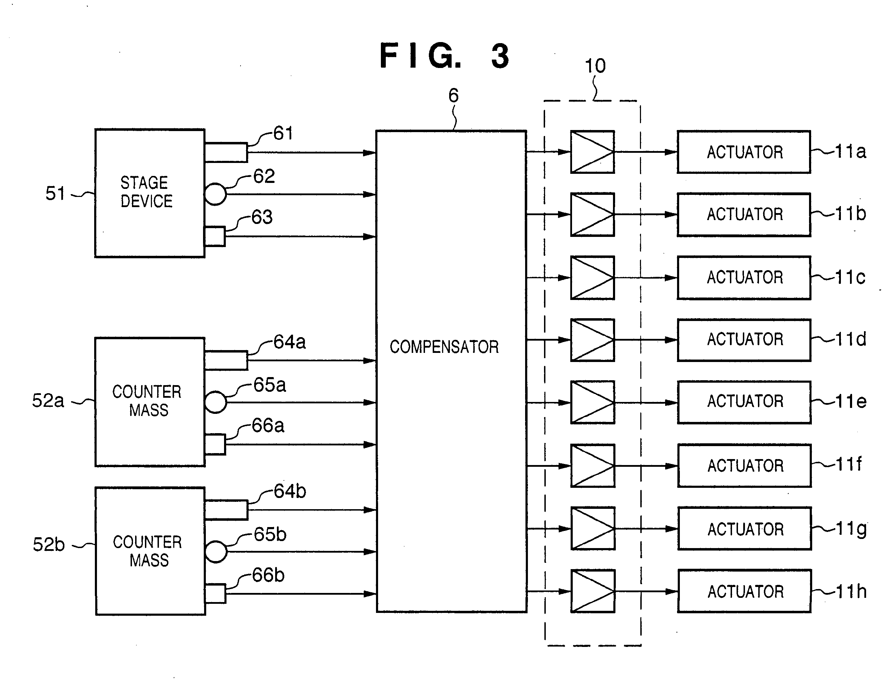

The base 1 includes actuators 11 (11a to 11h) which apply a control force to the base 1. The thrust generated by the actuators 11 (11a to 11h) is controlled on the basis of signals obtained by a compensator 6 shown in Fig. 3.

As shown in Fig. 3, output signals from the position sensor 61, velocity sensor 62, acceleration sensor 63, position sensors 64a and 64b, velocity sensors 65a and 65b, and acceleration sensors 66a and 66b are input to the compensator 6 and compensated. The actuators 11 (11a to 11h) are driven by a driving circuit 10 on the basis of the operation results obtained by the compensator 6.

In Figs. 1 to 3, the actuators 11 include the eight actuators 11a to 11h. The number of actuators 11 is not limited to eight as far as it is sufficient to realize a required control performance.

As shown in Figs. 1 and 2, the actuators 11 (11a to 11h) which apply the control force to the base 1 include at least either the actuators (11a to 11d) which apply a control force to the base 1 in the vertical direction or the actuators (11e to 11h) which apply a control force to the base 1 in the horizontal direction. Because of the control arrangement to be described later, if substantially no control force need be applied, some of the actuators 11 (11a to 11h) may be omitted. As the actuators 11 which apply the control force to the base 1, electromagnetic driving linear motors or the like are desirably used.

As the anti-vibration supports 2 which support the base 1 in an anti-vibration manner, it is desirable to use one having a pneumatic driving actuator including a pneumatic spring and an electropneumatic proportional valve or the like which adjusts the internal pressure of the pneumatic spring. In this case, a position sensor which detects and outputs a displacement amount (position information) of the base 1 from a reference position and a vibration sensor which detects and outputs the velocity information or acceleration information of the base 1 are desirably arranged. A base vibration compensator is desirably formed which performs compensation to decrease the vibration of the base on the basis of at least one of the output signal from the position sensor and the output signal from the vibration sensor. The pneumatic driving actuator is desirably controlled on the basis of the compensation result obtained by the base vibration compensator, so that the control operation is performed to decrease the vibration of the base 1. More specifically, an active vibration-damping device is desirably formed which maintains the position and posture of the base 1 in a predetermined state by using the position sensor, vibration sensor, base vibration compensator, pneumatic driving actuator, and the like, and actively controls the vibration of the base 1.

When the active vibration-damping device is used as the anti-vibration supports 2, the actuators 11 (11a to 11h) may be used as the actuators that control the vibration of the base 1 on the basis of an output signal from a base vibration sensor. When such an active vibration-damping device is employed, the vibration of the base 1 which is caused by a disturbance transmitted to the base 1 can be decreased quickly and appropriately.

The semiconductor exposure apparatus according to this embodiment includes the constituent elements described above. The operation of the semiconductor exposure apparatus according to this embodiment will be described in detail.

In the semiconductor exposure apparatus according to this embodiment, when the stage device 51 shown in Fig. 1 is driven in a direction of an arrow a shown in Fig. 1 on the basis of a drive command signal obtained by compensating the position detection signal from the position sensor 61, the counter masses 52a and 52b operate in directions of arrows Aa and Ab shown in Fig. 1, i.e., in the direction of the same degree of freedom as that of the stage device 51 but in the opposite direction.

This operation takes place when a thrust generated between the movable element of the stage driving linear motor attached to the stage device 51 and the stator of the stage driving linear motor attached to the counter masses 52a and 52b is exerted on the stage device 51 and counter masses 52a and 52b which are both supported movably.

In the stage system having this structure, the reaction force of the driving force which is generated when the stage device 51 is driven is transmitted not to the base 1 where the stage system is mounted but to the counter masses 52a and 52b. Thus, the energy of the driving reaction force is converted into the kinetic energies of the counter masses 52a and 52b. The force acting on the base 1 can be greatly reduced than in the conventional stage device in which the stator of the stage driving linear motor is fixed to the base. As a result, the vibration of the base 1 can be suppressed small.

Ideally, the stage device 51 having the above structure desirably operates such that its kinetic energy and momentum are entirely transmitted to the counter masses 52a and 52b while a force caused by stage driving is not transmitted to the base 1 at all. Then, no disturbance acts on the base 1, and no vibration is caused by disturbance.

Sometimes, however, the kinetic energy, momentum, driving reaction force, and the like of the stage device 51 are not entirely transmitted to the counter masses 52a and 52b due to the friction force and damping force generated in the bearings (not shown) of the stage device 51 and counter masses 52a and 52b and by forces or the like which are generated when the wiring lines and pipes extending from the base 1 to the stage device 51 and counter masses 52a and 52b serve as springs. In this case, the kinetic energy and momentum of the stage device 51 do not balance with the kinetic energy and momentum of the counter masses 52a and 52b. The difference in kinetic energy and momentum is transmitted to the base 1 where both the stage device 51 and counter masses 52a and 52b are mounted. Consequently, vibration occurs in the base 1.

In the exposure apparatus according to this embodiment, the kinetic energy, momentum, and driving reaction force that cannot be completely canceled between the stage device 51 and counter masses 52a and 52b are estimated from the motion physical values such as position information (displacement), velocity information, and acceleration information of the stage device 51 and counter masses 52a and 52b. The actuators which apply the control force to the base 1 are controlled on the basis of the estimated signals to decrease the vibration of the base 1.

The practical control operation of the exposure apparatus according to this embodiment will be described. First, a device which performs the control operation by estimating the thrust, momentum, and the like transmitted to the base 1 on the basis of the acceleration signals of the stage device 51 and counter masses 52a and 52b, and a control method for the device will be described.

The stage device 51 shown in Fig. 1 is driven by the drive command signal in accordance with a predetermined driving pattern. The counter masses 52a and 52b are operated by the driving reaction force of the stage device 51 in a direction opposite to the driving direction of the stage device 51. At this time, the acceleration information of the stage device 51 and counter masses 52a and 52b is detected by the acceleration sensors 63, 66a, and 66b. The output signals from the acceleration sensors are input to the compensator 6. The compensator 6 estimates the driving reaction force of the stage device 51 which cannot be canceled by the operation of the counter masses 52a and 52b.

In the case of a stage device which is driven in the direction of one degree of freedom, the driving reaction force acts in the stage driving direction with one translational degree of freedom and directions of two rotational degrees of freedom about two axes perpendicular to the stage driving direction. Accordingly, the relationship between the thrust and momentum of the stage device and those of the counter masses is formulated concerning the kinetic directions of the three degrees of freedom.

Regarding the thrust and momentum components of the stage device and counter masses which are proportional to the accelerations, the following equation of motion is established:

$$\begin{bmatrix} fy \\ Mqx \\ Mqz \end{bmatrix} = \begin{bmatrix} m & M1 & M2 \\ m \times lz0 & M1 \times lz1 & M2 \times lz2 \\ m \times lx0 & M1 \times lx1 & M2 \times lx2 \end{bmatrix} \begin{bmatrix} ay \\ aY1 \\ aY2 \end{bmatrix}$$

$$...(1)$$

where m, M1, and M2 are the masses of the stage device 51 and counter masses 52a and 52b, respectively, ay, aY1, and aY2 are the acceleration information of the stage device 51 and counter masses 52a and 52b, respectively, lz0 to lz2 are the Z-coordinates of the positions of centers of gravity of the stage device 51 and counter masses 52a and 52b with reference to the position of center of gravity of the base 1 as the origin point, and lx0 to lx2 are the X-coordinates of the positions of centers of gravity of the stage device 51 and counter masses 52a and 52b with reference to the position of center of gravity of the base 1 as the origin point. lz0 to lz2 and lx0 to lx2 can be obtained from the mechanical design information and the like of the stage device 51 and counter masses 52a and 52b. In the XYZ coordinate system, as shown in Figs. 1 and 2, the operating direction (direction of horizontal one degree of freedom) of the stage device 51 and counter masses 52a and 52b is defined as the Y-axis, a horizontal axis perpendicular to the Y-axis is defined as the X-axis, and the vertical axis is defined as the Z-axis. Also, the rotational directions about the X-, Y-, and Z-axes are respectively defined as θx, θy, and θz.

fy, Mqx, and Mqz in the left member are the thrust and moment in the Y, θx, and θz directions which are left without being canceled by the operation of the stage device 51 and the operations of the counter masses 52a and 52b. In other words, fy, Mqx, and Mqz are the differences in operation between the stage device and counter masses. If fy, Mqx, and Mqz are not zero, the thrust and moment are not canceled between the stage device and counter masses but leak to another portion, i.e., the base 1.

When the control force is distributed among the actuators 11 (11a to 11h) to cancel the thrust corresponding to the left member of the equation, even if the stage driving reaction forces are not canceled between the stage device and counter masses and leaking forces are input to the base 1, they can be canceled by the actuators 11 (11a to 11h) to decrease the vibration of the base 1.

The compensator 6 estimates fy, Mqx, and Mqz in the left member in accordance with equation (1), and generates control command signals to control the actuators 11 (11a to 11h) which apply a control force to the base 1, in order to cancel fy, Mqx, and Mqz. More specifically, the compensator 6 subjects estimated fy, Mqx, and Mqz to gain compensation and filtering when necessary. When the actuators 11 are high-response actuators such as electromagnetic driving linear motors, the compensator 6 can perform control calculation of mainly gain compensation on the basis of the information on fy, Mqx, and Mqz which are estimated in accordance with equation (1), and distribute the obtained control command signal among the respective actuators.

In this case, the thrust to be generated by the actuators 11 (11a to 11h) is estimated as thrusts fy, Mqx, and Mqz in the Y, θx, and θz directions. The compensator 6 calculates distributional thrusts to distribute the thrusts among the plurality of actuators 11 (11a to 11h), in order to generate desired thrusts and moments introduced on the basis of equation (1) in the Y, θx, and θz directions respectively. Thrust distribution equation can be formulated on the basis of the geometric arrangement of the actuators 11 (11a to 11h) and their arranging directions.

The plurality of actuators 11 (11a to 11h) are driven on the basis of the control command signals introduced by the compensator 6 in this manner, in order to apply a control force to the base 1. The thrusts and moments which are generated in accordance with equation (1) and cannot be completely canceled by the stage device 51 and counter masses 52a and 52b but transmitted to the base 1 are canceled by the actuators 11 in a real-time manner. Consequently, the vibration of the base 1 can be suppressed small.

In an apparatus which includes the stage device 51 and counter masses 52a and 52b and decreases the stage driving reaction force by their mutual operations, the stage driving reaction force can be canceled and decreased by the mutual operations of the constituent elements, thus decreasing the vibration of the base where the constituent elements are mounted. If, however, the mutual operations cannot completely cancel the stage driving reaction force and a thrust and moment are left to be transmitted to the base where the stage device 51 and counter masses 52a and 52b are mounted, the force acting on the base must be decreased by using some means.

In the exposure apparatus according to this embodiment, as described above, the thrust and moment which are not completely canceled by the operations of the stage device 51 and counter masses 52a and 52b but transmitted to the base 1 are estimated on the basis of the signals from the sensors which detect the motion physical values, e.g., the acceleration information, of the stage device 51 and counter masses 52a and 52b, and the actuators which apply the control force to the base 1 are controlled on the basis of the estimated thrust and moment. Thus, a higher vibration control performance that cannot be obtained by the conventional apparatus can be obtained. Consequently, the vibration of the stage device and other precision devices mounted on the base is decreased to realize an improvement in performance of the devices to be mounted on the exposure apparatus or the like.

In the above description, for the sake of descriptive simplicity, the thrust to be transmitted to the base 1 is only a term proportional to the acceleration. In fact, however, exchange of a force and moment which cannot be expressed by only a term proportional to the acceleration are not sometimes negligible, e.g., friction in pneumatic bearings to movably support the stage device 51 and counter masses 52a and 52b, or resistance caused by a counter electromotive force generated between the movable portion and stationary portion of the linear motor which forms the stage device. In this case, the thrust and moment transmitted to the base 1 can be estimated by adding a term proportional to the velocity and a term proportional to the position. The thrust and moment transmitted to the base 1 can be estimated by the following equation. Regarding the term proportional to the velocity in the following equation, not only the velocities of the stage device and counter masses with respect to the base 1, but also the relative velocity between the stage device and counter masses is considered.

$$
\begin{bmatrix} fy \\ Mqx \\ Mqz \end{bmatrix} = \begin{bmatrix} m & M1 & M2 \\ m \times lz0 & M1 \times lz1 & M2 \times lz2 \\ m \times lx0 & M1 \times lx1 & M2 \times lx2 \end{bmatrix} \begin{bmatrix} ay \\ aY1 \\ aY2 \end{bmatrix}
$$

$$
+ \begin{bmatrix} d11 & d12 & d13 \\ d21 & d22 & d23 \\ d31 & d32 & d33 \end{bmatrix} \begin{bmatrix} vy \\ vY1 \\ vY2 \end{bmatrix} + \begin{bmatrix} k11 & k12 & k13 \\ k21 & k22 & k23 \\ k31 & k32 & k33 \end{bmatrix} \begin{bmatrix} py \\ pY1 \\ pY2 \end{bmatrix}
$$

$$
\dots(2)
$$

In equation (2), the same symbols as in equation (1) represent the same parameters. Also, vy, vY1, and vY2 are the velocities of the stage device 51 and counter masses 52a and 52b, respectively, py, pY1, and pY2 are the positions (displacements) of the stage devices 51 and counter masses 52a and 52b, respectively, and dij and kij (i, j = 1, 2, 3) are a term proportional to the velocity and a term proportional to the position, respectively.

The term proportional to the velocity and the term proportional to the position may be experimentally estimated by, e.g., fixing any two of the stage device 51 and counter masses 52a and 52b immobile, applying a control force to the linear motor, and measuring the response characteristics of the respective motion physical values (ay, aY1, aY2, vy, vY1, vY2, py, pY1, and pY2).

In equations (1) and (2), as the term proportional to the acceleration, the mass m of the stage device 51 and the masses M1 and M2 of the counter masses 52a and 52b are used. When the values of the masses m, M1, and M2 are not clearly known, they may be experimentally obtained in the same manner.

The structure for controlling the actuators on the basis of the thrusts and moments estimated by the above equation (2) to decrease and suppress the vibration of the base is the same as that described above, and a description thereof will be omitted.

When the term proportional to the velocity and the term proportional to the position are considered in this manner, the thrust and moment to be transmitted from the stage system to the base 1 can be estimated more accurately, and the vibration of the base 1 can be suppressed and decreased more effectively.

In actual control operation, not all the motion physical values of the position information (displacement), velocity information, and acceleration information of the stage device 51 and counter masses 52a and 52b need be used for control. As far as a sufficient effect can be obtained, a structure which uses at least one of the position information (displacement), velocity information, and acceleration information is also included in the present invention. Naturally, a control operation may be performed in which only a term proportional to the acceleration is considered as in equation (1). In this case, sensors which detect motion physical values that are not to be used may be omitted. Such control operation may be performed not for all of the Y, θx, and θz directions but for at least one of them when necessary.

As apparent from equation (2), fy, Mqx, and Mqz can also be determined by the values of vx, vY1, and vY2. The motion physical values concerning these velocity information may be obtained not by using a velocity sensor as in the above description, but output signals from relative velocity sensors which are the relative velocities (vx - vY1) and (vx - vY2) between the stage device and counter masses may be used as the motion physical values.

Means for obtaining the position information (displacement), velocity information, and acceleration information of the stage device and counter masses are not limited to sensors which detect their motion physical values. For example, the position information (displacement), velocity information, and acceleration information can naturally be obtained on the basis of the drive profile information on the stage device and counter masses.

[Second Embodiment]

In the first embodiment, the stage device operates in the direction of one degree of freedom. This stage device corresponds to the reticle stage device 95 in the exposure apparatus described with reference to Fig. 7. The structure of the present invention can also be applied to a stage device, e.g., a substrate stage, which moves in the directions of two degrees of freedom. In a stage system including a stage device which operates in the directions of two degrees freedom and counter masses configured to cancel the driving reaction force of the stage device, a device will be described in which a thrust and moment which are not completely canceled by the mutual operations of the stage device and counter masses but transmitted to a base where the stage device and counter masses are mounted are estimated, and actuators which apply a control force to the base are controlled on the basis of estimation signals to decrease and suppress the vibration of the base.

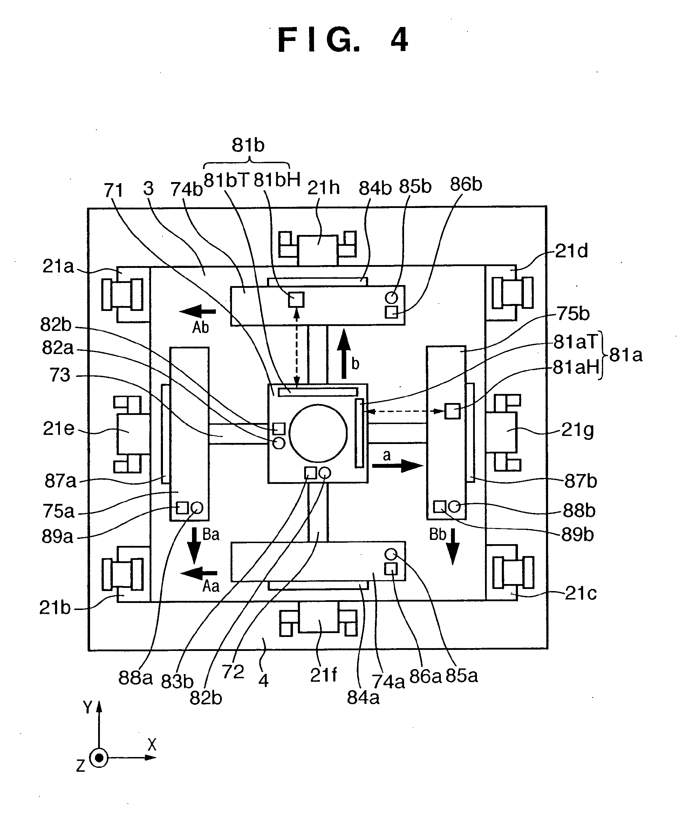

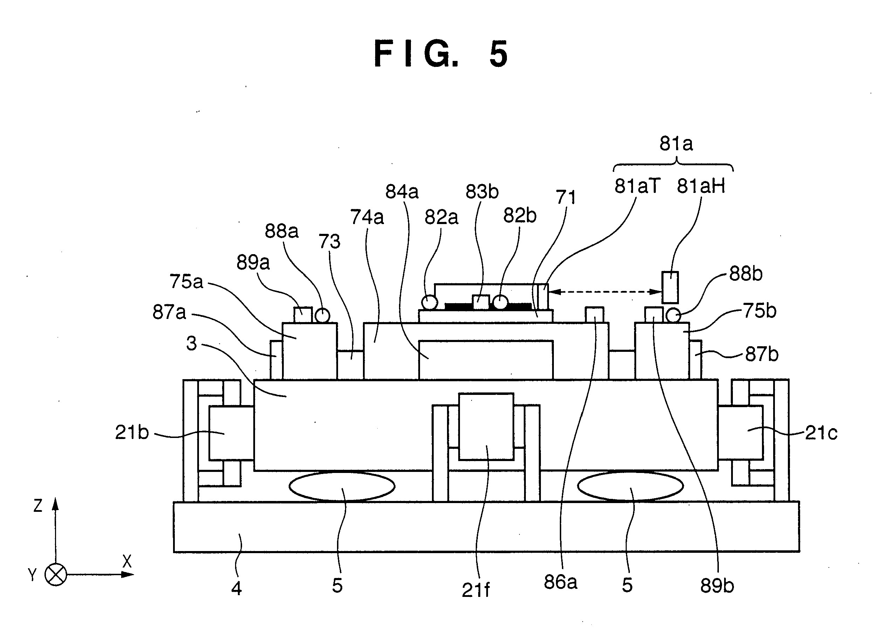

Figs. 4 and 5 are views for explaining the structure and operation of a unit around a stage device that forms an exposure apparatus according to the second preferred embodiment of the present invention. Figs. 4 and 5 show a stage device having a kinetic freedom in the directions of two degrees of freedom. Fig. 4 is a plan view of the exposure apparatus, and Fig. 5 is a side view of the exposure apparatus. This unit corresponds to the substrate stage device 94 in the exposure apparatus shown in Fig. 7. As the substrate stage device 94, a stage device having a kinetic freedom in directions of two degrees of freedom, e.g., an X-Y stage, is employed which repeatedly exposes the pattern on the reticle to print a plurality of patterns onto the substrate.

As shown in Figs. 4 and 5, the exposure apparatus according to the second preferred embodiment of the present invention includes the following constituent elements. More specifically, in the apparatus according to this embodiment, a stage device 71 on which a placing target such as a substrate is to be mounted is a structure which can move in the directions of two degrees of freedom, e.g., X and Y directions, and can be moved in the X direction by an X-direction moving member 72 and in the Y direction by a Y-direction moving member 73. The X-Y stage 71 is supported on a crossbar structure formed of the X-direction moving member 72 and Y-direction moving member 73 which do not restrict the operations of each other, and can move in both the X and Y directions. In the coordinate system, the two orthogonal horizontal axes form X- and Y-axes, the vertical axis forms the Z-axis, and rotational directions about the X-, Y-, and Z-axes form $\theta x$, $\theta y$, and $\theta z$ axes, respectively.

The stage device 71 includes X-direction counter masses 74a and 74b serving as load masses supported by a structure movable in the X direction, and Y-direction counter masses 75a and 75b serving as load masses supported by a structure movable in the Y direction.

An X-direction linear motor applies a thrust between the X-direction moving member 72 and X-direction counter masses 74a and 74b. In this case, the X-direction moving member 72 serves as a movable element, and the X-direction counter masses 74a and 74b serve as stators. Similarly, a Y-direction linear motor applies a thrust between the Y-direction moving member 73 and Y-direction counter masses 75a and 75b. In this case, the Y-direction moving member 73 serves as a movable element, and the Y-direction counter masses 75a and 75b serve as stators. The X-direction moving member 72 and Y-direction moving member 73 are driven by these linear motors to drive the stage device 71 in the X and Y directions.

In this stage system, when the stage device 71 is driven by the linear motor through the X-direction moving member 72 and Y-direction moving member 73, its driving reaction force acts on the X-direction counter masses 74a and 74b and Y-direction counter masses 75a and 75b to operate in the same directions in which the driving reaction force of the stage device 71 acts. The stator of the linear motor which drives the stage device 71 is supported on a base 3 where the stage device 71 is mounted through a movable structure. Even when the linear motor is driven to operate the stage, the energy and momentum of the stage driving reaction force form the kinetic energy and momentum of the counter masses including the linear motor stators and load masses. In an ideal state, the force is not transmitted to the base 3, and the stage can be operated without largely vibrating the base 3 where the stage system including these constituent elements is mounted.

In the semiconductor exposure apparatus according to this embodiment, sensors are employed for the stage device 71 having the above structure and the X-direction counter masses 74a and 74b and Y-direction counter masses 75a and 75b to detect their motion physical values.

More specifically, the stage device 71 includes a position sensors 81a (81aT and 81aH) and 81b (81bT and 81bH) which detect and output the position information of the stage device 71 in the respective directions of the degrees of freedom, i.e., in the X and Y directions, velocity sensors 82a and 82b which detect and output the velocity information of the stage device 71 in the respective directions of the degrees of freedom, i.e., in the X and Y directions, and acceleration sensors 83a and 83b which detect and output the acceleration information of the stage device 71 in the respective directions of the degrees of freedom, i.e., the X and Y directions.

The X-direction counter masses 74a and 74b respectively include position sensors 84a and 84b which detect and output the position information of the corresponding counter masses, velocity sensors 85a and 85b which detect and output the velocity information of the corresponding counter masses, and acceleration sensors 86a and 86b which detect and output the acceleration information of the corresponding counter masses.

Similarly, the Y-direction counter masses 75a and 75b respectively include position sensors 87a and 87b which detect and output the position information of the corresponding counter masses, velocity sensors 88a and 88b which detect and output the velocity information of the corresponding counter masses, and acceleration sensors 89a and 89b which detect and output the acceleration information of the corresponding counter masses.

The position sensors 84a and 84b, and 87a and 87b, velocity sensors 85a and 85b, and 88a and 88b, and acceleration sensors 86a and 86b, and 89a and 89b respectively detect the motion physical values, i.e., the position information, velocity information, and acceleration information in the operating directions of the X-direction counter masses 74a and 74 and Y-direction counter masses 75a and 75b.

As the position sensor 81 (81a and 81b) which detects and outputs the position information of the stage device 71, a laser interferometer which is widely used in this field because of the requirements in accuracy or the like is preferably used.

As the velocity sensor 82 (82a and 82b) which detects and outputs the velocity information of the stage device 71, a geophone sensor or another type of velocity sensor can be used. As the acceleration sensor 83 (83a and 83b) which detects and outputs the acceleration information of the stage device 71, various types of servo or piezoelectric accelerometers can be used.

When a laser interferometer is used as the position sensor 81, in place of using the velocity sensor 82 and acceleration sensor 83, the motion physical values of the output signals of the laser interferometer may be converted appropriately to calculate the velocity and acceleration.

Similarly, as the position sensors 84a and 84b, and 87a and 87b which detect and output the position information of the respective X-direction counter masses 74a and 74b and Y-direction counter masses 75a and 75b, various types of position sensors such as laser interferometers or encoders can be used.

As the velocity sensors 85a and 85b, and 88a and 88b which detect and output the velocity information of the X-direction counter masses 74a and 74b and Y-direction counter masses 75a and 75b, geophone sensors or another type of velocity sensors can be used. As the acceleration sensors 86a and 86b, and 89a and 89b which detect and output the acceleration information of the X-direction counter masses 74a and 74b and Y-direction counter masses 75a and 75b, various types of servo or piezoelectric accelerometers can be used.

When laser interferometers are used as the position sensors 84a, 84b, 87a, and 87b, in place of using the velocity sensors 85a, 85b, 88a, and 88b and acceleration sensors 86a, 86b, 89a, and 89b, the motion physical values of the output signals from the laser interferometers may be converted appropriately to calculate the velocities and accelerations.

In employing a control scheme to be described later, assume that the apparatus operates without any problem when at least one of the sensors is omitted. In this case, at least one of the position sensors 81a, 81b, 84a, 84b, 87a, and 87b, at least one of the velocity sensors 82a, 82b, 85a, 85b, 88a, and 88b, and at least one of the acceleration sensors 83a, 83b, 86a, 86b, 89a, and 89b may be omitted.

The stage system which includes the stage device 71, X-direction counter masses 74a and 74b, and Y-direction counter masses 75a and 75b described above is mounted on the base 3. The base 3 is supported on a foundation structure 4 set on an apparatus installation foundation by anti-vibration supports 5 in an anti-vibration manner. The base 3 includes actuators 21 (21a to 21h) which apply a control force to the base 3. The thrusts generated by the actuators 21 (21a to 21h) are controlled on the basis of signals obtained by a compensator 6b.

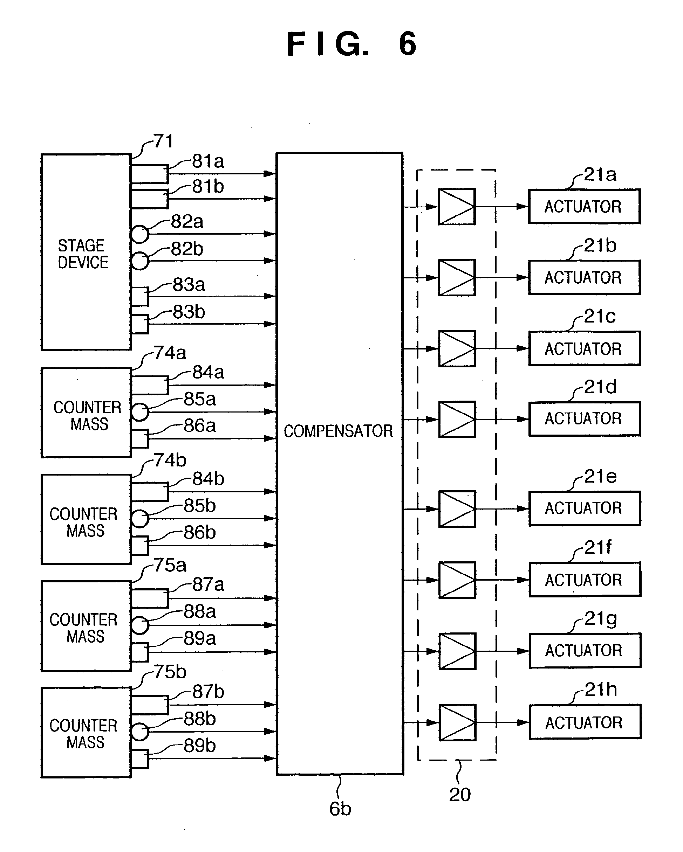

Output signals from the position sensors 81a and 81b, velocity sensors 82a and 82b, acceleration sensors 83a and 83b, position sensors 84a, 84b, 87a, and 87b, velocity sensors 85a, 85b, 88a, and 88b, and acceleration sensors 86a, 86b, 89a, and 89b are input to the compensator 6b and compensated, as shown in Fig. 6. The actuators 21 (21a to 21h) are driven through a driving circuit 20 on the basis of the operation results obtained by the compensator 6b.

In Figs. 4 to 6, the actuators 21 include the eight actuators 21a to 21h. The number of actuators 21 is not limited to eight as far as it is sufficient to realize a required control performance.

As shown in Figs. 4 and 5, the actuators 21 (21a to 21h) which apply the control force to the base 3 include actuators (21a to 21d) which apply a control force to the base 3 in the vertical direction and actuators (21e to 21h) which apply a control force to the base 3 in the horizontal direction. Because of the control arrangement to be described later, if substantially no control force need be applied, at least one of the actuators can be omitted. As the actuators 21 which apply the control force to the base 3, electromagnetic driving linear motors or the like can be suitably used.

As the anti-vibration supports 5, those which are identical to those described in the first embodiment can be used. Naturally, active vibration-damping devices having the same structure as that described in detail in the first embodiment can also be used as the anti-vibration supports 5. In a precision device such as an exposure apparatus, the necessity of accurately controlling the position and vibration of the base 3 where the devices are mounted is high. Accordingly, as the anti-vibration supports 5, it is desirable to employ active vibration-damping devices.

The semiconductor exposure apparatus according to this embodiment includes the constituent elements described above. The operation of the semiconductor exposure apparatus according to this embodiment will be described in detail.

In the semiconductor exposure apparatus according to this embodiment, when the stage device 71 and X-direction moving member 72 operate in the direction (X direction) of the arrow a shown in Fig. 4 on the basis of a drive command signal from the controller of the exposure apparatus, the X-direction counter masses 74a and 74b operate in the directions of arrows Aa and Ab shown in Fig. 4, i.e., in the direction of the same degree of freedom as that of the stage device 71 but in the opposite direction. When the stage device 71 and Y-direction moving member 73 operate in the direction (Y direction) of the arrow b shown in Fig. 4 on the basis of a drive command signal from the controller of the exposure apparatus, the Y-direction counter masses 75a and 75b operate in the directions of arrows Ba and Bb shown in Fig. 4, i.e., in the direction of the same degree of freedom as that of the stage device 71 but in the opposite direction. This operation takes place when a thrust generated between the movable elements of the stage driving linear motors attached to the X-direction moving member 72 and Y-direction moving member 73 and the stators of the stage driving linear motors attached to the X- and Y-direction counter masses 74a and 74b and 75a and 75b is exerted on the stage device 71, X-direction moving member 72, and Y-direction moving member 73, and the X-direction counter masses 74a and 74b and Y-direction counter masses 75a and 75b which are supported movably.

In the stage system having this structure, the reaction force of the driving force which is generated when the stage device 71 is driven is transmitted not to the base 3 where the stage system is mounted but to the X- and Y-direction counter masses. Thus, the energy of the driving reaction force is converted into the kinetic energies and momenta of not the base 3 but of the X-direction counter masses 74a and 74b and Y-direction counter masses 75a and 75b. The force acting on the base 3 can be greatly reduced as compared with the conventional stage device in which the stator of the stage driving linear motor is fixed to the base. As a result, the vibration of the base 3 can be suppressed small.

Ideally, the stage device 71 having the above structure desirably operates such that the kinetic energies and momenta of the stage device 71, X-direction moving member 72, and Y-direction moving member 73 are entirely transmitted to the X-direction counter masses 74a and 74b and Y-direction counter masses 75a and 75b while a force and moment caused by stage driving are not transmitted to the base 3 at all. Then, no disturbance acts on the base 3, and no vibration is caused by disturbance.

Assume that the kinetic energies, momenta, driving reaction forces, and the like of the stage device 71, X-direction moving member 72, and Y-direction moving member 73 are not entirely transmitted to the X-direction counter masses 74a and 74b and Y-direction counter masses 75a and 75b due to the friction force and damping force generated in the bearings (not shown) and influences and the like which are generated when the wiring lines and pipes extending from the base 3 to the stage device 71, X-direction moving member 72, Y-direction moving member 73, and X- and Y-direction counter masses serve as springs. In this case, the kinetic energies and momenta of the stage device 71, X-direction moving member 72, and Y-direction moving member 73 do not balance with the kinetic energies and momenta of the X-direction counter masses 74a and 74b and Y-direction counter masses 75a and 75b. The difference in kinetic energy and momentum is transmitted to the base 3 where both the stage device 71 are mounted. Consequently, vibration occurs in the base 3.

In the semiconductor exposure apparatus according to this embodiment, the kinetic energy, momentum, and driving reaction force that cannot be completely canceled between the stage device 71 and the X-direction counter masses 74a and 74b and Y-direction counter masses 75a and 75b are estimated from the motion physical values such as position information (displacement), velocity information, and acceleration information of the stage device and counter masses. The actuators which apply the control force to the base 3 are controlled on the basis of the estimated signals to decrease the vibration of the base 3.

The practical control operation of the semiconductor exposure apparatus according to this embodiment will be described. First, a device which performs the control operation by estimating the thrust, momentum, and the like transmitted to the base 3 on the basis of the acceleration signals of the stage device 71 and counter masses 74a, 74b, 75a, and 75b, and a control method for the device will be described.

The stage device 71 is driven by the drive command signal in accordance with a predetermined driving pattern. The X-direction counter masses 74a and 74b and the Y-direction counter masses 75a and 75b are operated by the X- and Y-direction driving reaction forces, respectively, of the stage device 71 in a direction opposite to the driving direction of the stage device 71. At this time, the X-direction acceleration information and Y-direction acceleration information of the stage device 71, the pieces of the X-direction acceleration information of the X-direction counter masses 74a and 74b, and the pieces of the Y-direction acceleration information of the Y-direction counter masses 75a and 75b are detected by the acceleration sensors 83a, 83b, 86a, 86b, 89a, and 89b. The output signals from the acceleration sensors are input to the compensator 6b.

The compensator 6b estimates the driving reaction force of the stage device 71 which cannot be canceled by the operations of the X-direction counter masses 74a and 74b and Y-direction counter masses 75a and 75b.

In the case of a stage device which is driven in the directions of two degrees of freedom as described herein, the driving reaction force acts in the stage driving directions with two translational degrees of freedom and directions of three rotational degrees of freedom about axes perpendicular to the stage driving direction. Accordingly, the relationship between the thrust and momentum of the stage device and those of the counter masses can be formulated concerning the kinetic directions of the five degrees of freedom.

Regarding the thrust and momentum components of the stage device and counter masses which are proportional to the accelerations, the following equation of motion is established:

$$
\begin{bmatrix} fx \\ fy \\ Mqx \\ Mqy \\ Mqz \end{bmatrix}
= \begin{bmatrix}
mx & 0 & M1 & M2 & 0 & 0 \\
0 & my & 0 & 0 & M3 & M4 \\
0 & m \times lz0 & 0 & 0 & M3 \times lz3 & M4 \times lz4 \\
m \times lz0 & 0 & M1 \times lz1 & M1 \times lz2 & 0 & 0 \\
m \times ly0 & m \times lx0 & M1 \times ly1 & M2 \times ly2 & M3 \times lx3 & M4 \times lx4
\end{bmatrix}
\begin{bmatrix} ax \\ ay \\ aX1 \\ aX2 \\ aY1 \\ aY2 \end{bmatrix}
$$

$$...(3)$$

where mx is the sum of the masses of the stage device 71 and X-direction moving member 72, my is the sum of the masses of the stage device 71 and Y-direction moving member 73, M1, M2, M3, and M4 are the masses of the X-direction counter mass 74a, X-direction counter mass 74b, Y-direction counter mass 75a, and Y-direction counter mass 75b, respectively, ax and ay are the X- and Y-direction accelerations, respectively, of the stage device 71, aX1 and aX2 are the X-direction accelerations of the X-direction counter masses 74a and 74b, respectively, aY1 and aY2 are the Y-direction accelerations of the Y-direction counter masses 75a and 75b, respectively, 1z0 to 1z4 are the Z-coordinates of the positions of centers of gravity of the stage device 71 and X- and Y-direction counter masses 74a and 74b, and 75a and 75b, respectively, with reference to the position of center of gravity of the base 3 as the origin point, ly0 to ly2 are the Y-coordinates of the positions of centers of gravity of the stage device 71 and X-direction counter masses 74a and 74b with reference to the position of center of gravity of the base 3 as the origin point, and 1x0, 1x3, and 1x4 are the X-coordinates of the positions of centers of gravity of the stage device 71 and Y-direction counter masses 75a and 75b with reference to the position of center of gravity of the base 3 as the origin point. In this case, 1z0 to lz4, ly0 to ly2, 1x0, lx3, and 1x4 can be obtained from the mechanical design information and the like of the stage device 71 and counter masses 74a, 74b, 75a, and 75b.

Thrusts and moments fx, fy, Mqx, Mqy, and Mqz in the left-hand side are left in the X, Y, θx, θy, and θz directions without being canceled by the operation of the stage device 71 and the operations of the X- and Y-direction counter masses 74a and 74b, and 75a and 75b. In other words, fx, fy, Mqx, Mqy, and Mqz are the differences in operation between the stage device and counter masses. If fx, fy, Mqx, Mqy, and Mqz are not zero, the thrusts and moments are not canceled between the stage device and counter masses but leak to another portion, i.e., the base 3.

When the thrust corresponding to the left member of this equation is distributed among the actuators 21 (21a to 21h), even if the stage driving reaction forces are not canceled between the stage device and counter masses and leaking forces are input to the base 3, the leaking forces can be canceled by the actuators 21 (21a to 21h) to decrease the vibration of the base 3.

The compensator 6b estimates fx, fy, Mqx, Mqy, and Mqz in the left member in accordance with equation (3), and generates control command signals to control the actuators 21 (21a to 21h) which apply a control force to the base 3, in order to cancel fx, fy, Mqx, Mqy, and Mqz. More specifically, the compensator 6b performs gain compensation and filtering to estimated fx, fy, Mqx, Mqy, and Mqz when necessary. When the actuators 21 are high-response actuators such as electromagnetic driving linear motors, the compensator 6b can perform control calculation of mainly gain compensation on the basis of the information on fx, fy, Mqx, Mqy, and Mqz which are estimated in accordance with equation (3), and distribute the obtained control command signal among the respective actuators. In this case, the thrust to be generated by the actuators 21 (21a to 21h) is given as thrusts and moments fx, fy, Mqx, Mqy, and Mqz in the X, Y, θx, θy, and θz directions. The compensator 6b calculates distributional thrusts to generate desired thrusts and moments introduced on the basis of equation (3) in the X, Y, θx, θy, and θz directions respectively, and to distribute the thrusts among the plurality of actuators 21 (21a to 21h). Thrust distribution equation can be formulated on the basis of the geometric arrangement of the actuators 21 (21a to 21h) and their arranging directions.

The plurality of actuators 21 (21a to 21h) are driven through the driving circuit 20 on the basis of the control command signals introduced by the compensator 6b in this manner, in order to apply a control force to the base. The thrusts and moments which are inevitably generated in accordance with equation (3) and cannot be completely canceled by the stage device 71 and X-direction counter masses 74a and 74b and Y-direction counter masses 75a and 75b but transmitted to the base 3 are canceled by the actuators 21 in a real-time manner. Consequently, the vibration of the base 3 can be suppressed small.

In an apparatus which includes the stage device 71, X-direction counter masses 74a and 74b, Y-direction counter masses 75a and 75b, and the like and decreases the stage driving reaction force by their mutual operations, the stage driving reaction force can be canceled and decreased by the mutual operations of the constituent elements, thus decreasing the vibration of the base where the constituent elements are mounted. If, however, the mutual operations cannot completely cancel the stage driving reaction force and a thrust and moment are left to be transmitted to the base where the stage device 71 and counter masses 74a, 74b, 75a, and 75b are mounted, the force acting on the base must be decreased by using some auxiliary means.

In the semiconductor exposure apparatus according to this embodiment, as described above, the thrust and moment which are not completely canceled by the operations of the stage device and X- and Y-direction counter masses but transmitted to the base are estimated on the basis of the signals from the sensors which detect the motion physical values, e.g., the acceleration information and the like, of the stage device and X- and Y-direction counter masses, and the actuators which apply the control force to the base are controlled on the basis of the estimated thrust and moment. Thus, a higher vibration control performance that cannot be obtained by the conventional apparatus can be obtained. Consequently, the vibration of the stage device and other precision devices mounted on the base is decreased to realize an improvement in performance of the devices to be mounted on the exposure apparatus or the like.

In the above description, for the sake of descriptive simplicity, the thrust to be transmitted to the base is only a term proportional to the acceleration. In fact, however, the relationship between a force and moment which cannot be expressed by only a term proportional to the acceleration are not sometimes negligible, e.g., friction in bearings to movably support the stage device and counter masses, resistance caused by a counter electromotive force generated between the movable portion and stationary portion of the linear motor which forms the stage device, or an influence generated when a wiring line or pipe acts as a spring among the stage device, counter masses, and base. In this case, the thrust and moment transmitted to the base 3 can be estimated by adding a term proportional to the velocity and a term proportional to the position. The thrust and moment transmitted to the base 3 can be estimated by the following equation (4). Regarding the term proportional to the velocity in the following equation, not only the velocities of the stage device and counter masses with respect to the base 3, but also the relative velocity between the stage device and counter masses is considered. Equation (4) is given as an equation having five degrees of freedom, since the stage device as the target is a system having two degrees of freedom. The basic idea of equation (4) is the same as that of equation (2).

$$
\begin{bmatrix} fx \\ fy \\ Mqx \\ Mqy \\ Mqz \end{bmatrix}
$$

$$
= \begin{bmatrix} m & 0 & M1 & M2 & 0 & 0 \\ 0 & m & 0 & 0 & M3 & M4 \\ 0 & m \times lz0 & 0 & 0 & M3 \times lz3 & M4 \times lz4 \\ m \times lz0 & 0 & M1 \times lz1 & M1 \times lz2 & 0 & 0 \\ m \times ly0 & m \times lx0 & M1 \times ly1 & M2 \times ly2 & M3 \times lx3 & M4 \times lx4 \end{bmatrix} \begin{bmatrix} ax \\ ay \\ aX1 \\ aX2 \\ aY1 \\ aY2 \end{bmatrix}
$$

$$
+ \begin{bmatrix} d11 & d12 & d13 & d14 & d15 & d16 \\ d21 & d22 & d23 & d24 & d25 & d26 \\ d31 & d32 & d33 & d34 & d35 & d36 \\ d41 & d42 & d43 & d44 & d45 & d46 \\ d51 & d52 & d53 & d54 & d55 & d56 \end{bmatrix} \begin{bmatrix} vx \\ vy \\ vX1 \\ vX2 \\ vY1 \\ vY2 \end{bmatrix}
$$

$$
+ \begin{bmatrix} k11 & k12 & k13 & k14 & k15 & k16 \\ k21 & k22 & k23 & k24 & k25 & k26 \\ k31 & k32 & k33 & k34 & k35 & k36 \\ k41 & k42 & k43 & k44 & k45 & k46 \\ k51 & k52 & k53 & k54 & k55 & k56 \end{bmatrix} \begin{bmatrix} px \\ py \\ pX1 \\ pX2 \\ pY1 \\ pY2 \end{bmatrix}
$$

... (4)

In equation (4), the same symbols as in equation (3) represent the same parameters. Also, vx and vy are the X- and Y-direction velocities, respectively, of the stage device 71, vX1 and vX2 are the X-direction velocities of the counter masses 74a and 74b, respectively, vY1 and vY2 are the Y-direction velocities of the counter mass 75a and 75b, respectively, px and py are the X- and Y-direction positions (displacements), respectively, of the stage device 71, pX1 and pX2 are the X-direction displacements of the counter masses 74a and 74b, respectively, pY1 and pY2 are the Y-direction displacements of the counter masses 75a and 75b, respectively, and dij and kij (i = 1, 2, ..., 5, j = 1, 2, ..., 6) are a term proportional to the velocity (velocity proportional gain) and a term proportional to the position (displacement proportional gain), respectively.

The structure for controlling the actuators on the basis of the thrusts and moments estimated by the above equation (4) to decrease and suppress the vibration of the base is the same as that described above, and a description thereof will be omitted.

When the term proportional to the velocity and the term proportional to the position are considered in this manner, the thrust and moment to be transmitted from the stage system to the base can be estimated more accurately, and the vibration of the base 3 can be suppressed and decreased more effectively.

In actual control operation, not all the motion physical values of the position information (displacement), velocity information, and acceleration information of the stage device and counter masses need be used for control. As far as a sufficient effect can be obtained, a control operation may be performed in which only a term proportional to the acceleration is considered as in equation (3). In this case, sensors which detect motion physical values that need not be used may be omitted. Such control operation may be performed not for all of the X, Y, θx, θy, and θz directions but for at least one of them when necessary.

In the same manner as in the first embodiment, sensors which detect the relative velocity of the stage device and counter masses may be provided, and the control may be performed by performing the above control operation by using relative velocity signals of the stage device and counter masses which are detected by the sensors. This is apparent from equation (4).

Means for obtaining the position information (displacement), velocity information, and acceleration information of the stage device and counter masses are not limited to sensors which detect their motion physical values. For example, the position information (displacement), velocity information, and acceleration information can naturally be obtained on the basis of the drive profile information on the stage device and counter masses.

[Third Embodiment]

The first and second embodiments exemplify an apparatus and structure for controlling the actuators which apply a control force to the base on the basis of the motion physical values, e.g., the position information (displacement), velocity information, and acceleration information of the stage device and counter masses. Equations (1) to (4) will be reviewed. For the sake of simplicity, equation (1) will be discussed.

According to the basic operation of a stage device, e.g., the stage device described in the present invention which includes counter masses, the motion physical values, e.g., position (displacement), velocity, and acceleration are transferred between the stage device and counter masses. Forces from the stage device and counter masses do not act on the base or the like where the stage device and counter masses are mounted. Considering this point, in an ideal state, for example, if the relationship of equation (5) is maintained, fy and Mqz in the left member of equation (1) become zero:

```
m x ay + M1 x aY1 + M2 x aY2 = 0

aY1 = aY2

lx0 = 0

lx1 = -lx2
```

$$...(5)$$

In this case, for example, if the sign of 1z0 and that of lz1 and lz2 are different, Mqx cannot become zero in any way. Then, the actuators are controlled on the basis of Mqx introduced in accordance with equation (1).

Regarding Mqx, as far as the relationship of equation (5) is almost satisfied, if the acceleration signal ay of the stage device can be observed, a necessary control force Mqx can be determined on the basis of only ay, so that an almost good vibration control performance can be obtained.

More specifically, depending on the mechanical design state of the stage device and counter masses and their control method, the compensator 6 can substantially estimate the acceleration information of the counter masses from the acceleration information of the stage device. When mechanical design information is added to the estimated acceleration information, the same control operation as that of the first embodiment can be realized by substantially using only the acceleration information of the stage device. The control method having this arrangement is also included in the scope of the present invention.

As the acceleration information of the stage device, an acceleration profile which defines the stage operation can be used. For the sake of descriptive simplicity, the present invention is directed to a control structure based on the calculation shown in equation (1). Note that the same control operation can be performed by equation (3) of the second embodiment.

[Fourth Embodiment]

In the structures described in the first to third embodiments, the behaviors of the stage device and counter masses in the horizontal direction are noted. In the apparatus of the present invention, variations in positions of centers of gravity of the loads, including the stage device and counter masses, on a base when the stage device and counter masses operate on the base which is supported in an anti-vibration manner, must also be noted.

In a stage using counter masses, as far as the kinetic energy and momentum are appropriately transferred between the stage device and counter masses, even when these loads shift, all of the positions of centers of gravity of the moving loads can be set substantially immobile. If, however, the kinetic energy and momentum cannot be completely canceled between the stage device and counter masses because of the reasons described in the first and second embodiments, the position of center of gravity of the moving loads as a whole sometimes fluctuates. If the position of center of gravity of the loads, including the stage device and counter masses, on the base fluctuates in this manner, this fluctuation spoils the moment balance of the base support system, thus inclining the base.

Even in this case, if motion physical value sensors of the stage device and counter masses are provided as in the apparatus of the present invention, fluctuations in center of gravity of the load on the base can be obtained in real time. In other words, the position of center of gravity of the load on the base can be estimated from the detection signals of the position information of the stage device and counter masses. When the actuators which apply a control force to the base are controlled in accordance with the fluctuation amount of the position of center of gravity, an inclination of base which is caused by the shift of the center of gravity of the loads on the base can be minimized.

A semiconductor exposure apparatus according to the fourth embodiment includes a compensator for operating actuators which apply a control force to a base on the basis of the detection signal of the motion physical value of at least one of the position information, velocity information, and acceleration information of the stage device, and the detection signal of the motion physical value of at least one of the position information, velocity information, and acceleration information of the counter masses. If this compensator also performs a control operation based on the shift of the center of gravity of the loads as described above, the vibration of the base can be minimized. More specifically, for example, when high-response electromagnetic driving linear motors are used as actuators, control operation may be performed on the basis of the position information of the stage device and counter masses. When low-response pneumatic driving actuators are used, control operation may be performed on the basis of velocity information which corresponds to the derivative information of the positions of the stage device and counter masses by considering the response speed of the actuators which substantially shows integral characteristics or primary delay characteristics in a necessary control band.

As described above, in the apparatus which includes the stage device and counter masses and cancels and decreases the stage driving reaction force by the mutual operations of the stage device and counter masses, a force which acts on the base where the stage device and counter masses are mounted can be decreased greatly. Even when the stage driving reaction force is large, the vibration of the base can be decreased effectively. When, however, the stage driving reaction force cannot be completely canceled by the mutual operations of the stage device and counter masses and a thrust and moment are transmitted to the base where the stage device and counter masses are mounted, the force acting on the base must be decreased by using some auxiliary unit.

With the semiconductor exposure apparatus according to this embodiment, as described above, a thrust and moment which are not completely canceled by the mutual operations of the stage device and counter masses but transmitted to the base are estimated on the basis of signals from means which measures the motion physical values such as the position information (displacement), velocity information, and acceleration information of the stage device and counter masses. The actuators which apply a control force to the base are controlled on the basis of the estimated thrust and moment. Thus, even when the stage driving reaction force cannot be completely canceled by the mutual operations of the stage device and counter masses, the thrust and moment which are transmitted to the base where the stage device and counter masses are mounted can be canceled. A higher vibration control performance that cannot be obtained with the conventional apparatus can be obtained. Consequently, the vibration of the stage device and other precision devices which are mounted on the base can be decreased to realize an improvement in performance of devices mounted on the exposure apparatus or the like.

[Application]

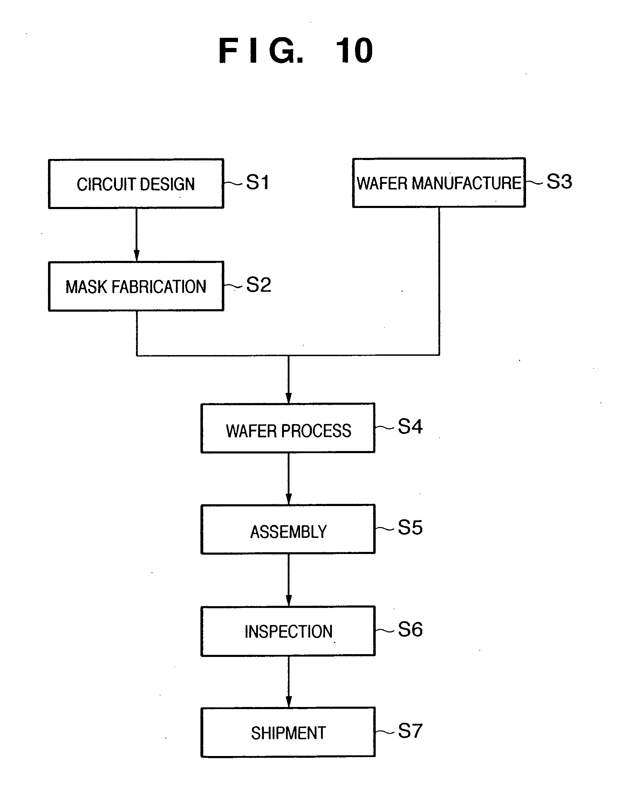

A semiconductor device manufacturing process which uses an exposure apparatus according to a preferred embodiment of the present invention will be described. Fig. 10 is a flowchart showing the flow of the entire semiconductor manufacturing process. In step 1 (circuit design), the circuit of a semiconductor device is designed. In step 2 (mask fabrication), a mask is fabricated on the basis of the designed circuit pattern. In step 3 (wafer manufacture), a wafer is manufactured using a material such as silicon. In step 4 (wafer process) called a preprocess, an actual circuit is formed on the wafer by the exposure apparatus described above in accordance with lithography using the mask and wafer described above. In the next step 5 (assembly) called a post-process, a semiconductor chip is formed using the wafer fabricated in step 4. This step includes processes such as assembly (dicing and bonding) and packaging (chip encapsulation). In step 6 (inspection), inspections such as operation check test and durability test of the semiconductor device fabricated in step 5 are performed. A semiconductor device is finished with these steps and shipped in step 7.

The wafer process of step 4 has the following steps, i.e., an oxidation step of oxidizing the surface of the wafer, a CVD step of forming an insulation film on the wafer surface, an electrode formation step of forming an electrode on the wafer by deposition, an ion implantation step of implanting ions in the wafer, a resist process step of applying a photosensitive agent to the wafer, an exposure step of transferring the circuit pattern to the wafer after the resist process step by the exposure apparatus described above, a developing step of developing the wafer exposed in the exposure step, an etching step of removing portions other than the resist image developed in the developing step, and a resist removal step of removing any unnecessary resist after etching. These steps are repeated to form multiple circuit patterns on the wafer.

As many apparently widely different embodiments of the present invention can be made without departing from the spirit and scope thereof, it is to be understood that the invention is not limited to the specific embodiments thereof except as defined in the claims.

An exposure apparatus includes a base, a stage device which is mounted on the base and moves in a predetermined direction, a counter mass which is mounted on the base and moves in a direction opposite to the predetermined direction as the stage device moves, a sensor which detects a motion physical value of each of the stage device and counter mass, and an actuator which applies a force to the base on the basis of a detection result of the sensor.

**Claims**

1. An exposure apparatus comprising:

     a base;
     a stage device which is mounted on said base and moves in a predetermined direction;
     a counter mass which is mounted on said base and moves in a direction opposite to the predetermined direction as said stage device moves;
     a sensor which detects a motion physical value of each of said stage device and counter mass; and
     an actuator which applies a force to said base on the basis of a detection result of said sensor.

2. The apparatus according to claim 1, wherein said sensor detects at least one of position information, velocity information, and acceleration information as the motion physical value.

3. The apparatus according to claim 1, further comprising a compensator which generates a control command signal to control said actuator,
   wherein said compensator generates the control command signal on the basis of a mass of each of said stage device and counter mass, the motion physical value detected by said sensor, and a position of center of gravity of each of said stage device and counter mass with reference to a position of center of gravity of said base as an origin point.

4. The apparatus according to claim 1, further comprising a compensator which generates a control command signal to control said actuator,
   wherein said compensator generates the control command signal on the basis of a mass of each of said stage device and counter mass, the motion physical value detected by said sensor, a position of center of gravity of each of said stage device and counter mass with reference to a position of center of gravity of said base as an origin point, a displacement proportional gain, and velocity proportional gain.

**5.** The apparatus according to claim 3, wherein said compensator generates the control command signal to cancel a driving reaction force which accompanies motion of said stage device and cannot be completely canceled by motion of said counter mass.

**6.** The apparatus according to claim 3, further comprising a relative velocity sensor which detects a relative velocity between said stage device and counter mass,
wherein said compensator generates the control command signal on the basis of a detection result of said relative velocity sensor.

**7.** The apparatus according to claim 3, wherein said compensator estimates acceleration information of said counter mass on the basis of acceleration information of said stage device.

**8.** The apparatus according to claim 3, wherein said compensator detects a change amount of a position of center of gravity of a load mounted on said base on the basis of the motion physical value detected by said sensor, and generates the control command signal in accordance with the change amount of the position of center of gravity.

**9.** The apparatus according to claim 1, wherein said actuator includes at least one of an actuator which applies a force to said base in a vertical direction and an actuator which applies a force to said base in a horizontal direction.

**10.** A semiconductor device manufacturing method comprising:

an exposure step of transferring a pattern of an original onto a substrate by using an exposure apparatus according to claim 1; and
a developing step of developing the substrate on which the pattern has been transferred.

# FIG. 1

EP 1 619 407 A1

# FIG. 2

EP 1 619 407 A1

# FIG. 3

EP 1 619 407 A1

# FIG. 4

# FIG. 5

# FIG. 6

# F I G. 7

# F I G.  8

# FIG. 9

# F I G. 10

```
┌──────────────────┐                      ┌──────────────────────┐
│  CIRCUIT DESIGN  │─S1                   │  WAFER MANUFACTURE   │─S3
└──────────────────┘                      └──────────────────────┘
         │                                           │
         ▼                                           │
┌──────────────────┐                                 │
│ MASK FABRICATION │─S2                              │
└──────────────────┘                                 │
         │                                           │
         └──────────────┐        ┌───────────────────┘
                        ▼        ▼
                 ┌──────────────────┐
                 │  WAFER PROCESS   │─S4
                 └──────────────────┘
                          │
                          ▼
                 ┌──────────────────┐
                 │     ASSEMBLY     │─S5
                 └──────────────────┘
                          │
                          ▼
                 ┌──────────────────┐
                 │    INSPECTION    │─S6
                 └──────────────────┘
                          │
                          ▼
                 ┌──────────────────┐
                 │     SHIPMENT     │─S7
                 └──────────────────┘
```

**European Patent Office**

**EUROPEAN SEARCH REPORT**

Application Number

EP 05 01 5330

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2003/197845 A1 (MORISADA MASAHIRO) 23 October 2003 (2003-10-23) * abstract; figure 1 * ----- | 1,2,6-10 | F16F7/10 G03F7/20 F16F15/02 |
| A | US 2002/003616 A1 (EBINUMA RYUICHI ET AL) 10 January 2002 (2002-01-10) * column 8 - column 9 * ----- | 1,10 | |
| A | US 6 408 045 B1 (MATSUI SHIN ET AL) 18 June 2002 (2002-06-18) * abstract; figures * ----- | 1,10 | |
| A | US 2002/179806 A1 (TENG TING-CHIEN) 5 December 2002 (2002-12-05) * claim 20; figure 7 * ----- | 1,10 | |
| A | US 2002/104950 A1 (MAYAMA TAKEHIKO) 8 August 2002 (2002-08-08) ----- | | |
| D,A | PATENT ABSTRACTS OF JAPAN vol. 1999, no. 02, 26 February 1999 (1999-02-26) & JP 10 311364 A (CANON INC), 24 November 1998 (1998-11-24) * abstract * ----- | | TECHNICAL FIELDS SEARCHED (Int.Cl.7) F16F G03F H01L G05D |

The present search report has been drawn up for all claims

| Place of search | Date of completion of the search | Examiner |
|---|---|---|
| The Hague | 1 November 2005 | Pemberton, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 01 5330

This annex lists the patent family members relating to the patent documents cited in  the above-mentioned European search report.
The members are as contained in the European Patent Office EDP file on
The European Patent Office is in no way  liable for these particulars which are merely  given for the purpose of information.

01-11-2005

| Patent document cited in search report | | Publication date | Patent family member(s) | | Publication date |
|---|---|---|---|---|---|
| US 2003197845 | A1 | 23-10-2003 | JP 2003314610 A<br>US 2005217956 A1 | | 06-11-2003<br>06-10-2005 |
| US 2002003616 | A1 | 10-01-2002 | JP 11189332 A | | 13-07-1999 |
| US 6408045 | B1 | 18-06-2002 | EP 0917004 A2 | | 19-05-1999 |
| US 2002179806 | A1 | 05-12-2002 | NONE | | |
| US 2002104950 | A1 | 08-08-2002 | JP 2002221249 A | | 09-08-2002 |
| JP 10311364 | A | 24-11-1998 | NONE | | |

For more details about this annex : see Official Journal of the European Patent Office, No. 12/82